(19) Europäisches Patentamt European Patent Office Office européen des brevets

(11) **EP 4 654 471 A1**

(12) **EUROPEAN PATENT APPLICATION**

(43) Date of publication:
**26.11.2025 Bulletin 2025/48**

(21) Application number: **24305803.9**

(22) Date of filing: **23.05.2024**

(51) International Patent Classification (IPC):
**H03F 1/22** *(2006.01)* **H03F 3/193** *(2006.01)*
**H03F 3/21** *(2006.01)* **H03F 3/24** *(2006.01)*
**H03F 3/72** *(2006.01)*

(52) Cooperative Patent Classification (CPC):
**H03F 3/245; H03F 1/223; H03F 3/193; H03F 3/211;**
**H03F 3/72;** H03F 2200/451; H03F 2200/555;
H03F 2200/75; H03F 2203/21148

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **NXP B.V.**
**5656 AG Eindhoven (NL)**

(72) Inventors:
• **Radin,, Rafael Luciano**
**31023 Toulouse (FR)**
• **Gambus,, Laurent**
**31023 Toulouse (FR)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire S051 9NJ (GB)**

(54) **A POWER RAMPING CIRCUIT**

(57) There is provided a power ramping circuit configured to generate a combined output signal comprising: a plurality of ramp slice circuits each configured to, upon activation, provide an output voltage, wherein the power ramping circuit is configured to combine the output voltages of the ramp slice circuits in order to provide the combined output signal, and wherein each ramp slice circuit comprises: a buffer circuit comprising a buffer amplifier; and a smoothing circuit configured to selectively operate in a current-limiting mode and a non-current-limiting mode and an RF power amplifier which is configured to amplify an input signal and wherein the amplification applied by the RF power amplifier is controlled by the buffer circuit.

Figure 1

Figure 2

EP 4 654 471 A1

**Description**

**Field**

The present disclosure relates to a power ramping circuit and a wireless transmitter device comprising said power ramping circuit.

**Summary**

According to a first aspect of the present disclosure, there is provided a power ramping circuit configured to generate a combined output signal for use by a wireless transmitter to generate a wireless signal, the power ramping circuit comprising: a plurality of ramp slice circuits wherein each ramp slice circuit is configured to, upon activation, provide an output voltage, wherein the power ramping circuit is configured to combine the output voltages of the plurality of ramp slice circuits in order to provide the combined output signal, and wherein each ramp slice circuit comprises: a buffer circuit comprising a buffer amplifier wherein the buffer amplifier comprises: an input terminal; an output terminal configured to provide the output control voltage of the ramp slice circuit; a positive supply terminal couplable to a positive supply node; and a negative supply terminal couplable to a reference node; and a smoothing circuit configured to selectively operate in a current-limiting mode and a non-current-limiting mode, an RF power amplifier which is configured to amplify an input signal and wherein the amplification applied by the RF power amplifier is controlled by the buffer circuit, wherein: in the current-limiting mode, the smoothing circuit is configured to restrict the current received by the buffer amplifier at the positive supply terminal and the negative supply terminal; and in the non-current limiting mode, the smoothing circuit is configured to not restrict the current received by the buffer amplifier at the positive supply terminal and the negative supply terminal.

In one or more embodiments, the power ramping circuit may be configured to selectively operate in either: a digital power ramp mode wherein the power ramping circuit is configured to activate each ramp slice circuit sequentially and wherein the smoothing circuit of each ramp slice circuit is configured to operate in the non-current-limiting mode; or an analogue power ramp mode wherein the power ramping circuit is configured to activate each of the ramp slice circuits simultaneously and wherein the smoothing circuit of each ramp slice circuit is configured to operate in the current-limiting mode.

In one or more embodiments, the plurality of ramp slice circuits may be arranged in parallel.

In one or more embodiments, the smoothing circuit may comprise: a first current limiting transistor, CLT, wherein the first CLT comprises a first CLT conduction channel and a first CLT control terminal wherein the voltage at the first CLT control terminal controls current flow through the first CLT conduction channel; and a second current limiting transistor, CLT, wherein the second CLT comprises a second CLT conduction channel and a second CLT control terminal, wherein the voltage at the second CLT control terminal controls current flow through the second CLT conduction channel, wherein: the first CLT conduction channel is arranged between the positive supply node and the positive supply terminal of the amplifier; and the second CLT conduction channel is arranged between the reference node and the negative supply terminal of the amplifier.

In one or more embodiments, the smoothing circuit may further comprise a first smoothing switch coupled in parallel with the first CLT and a second smoothing switch coupled in parallel with the second CLT, wherein opening and closing the first and second smoothing switches provides for selection of the current-limiting mode or the non-current-limiting mode.

In one or more embodiments, the first CLT control terminal may be coupled to a first reference voltage and the second CLT control terminal is coupled to a second reference voltage.

In one or more embodiments, the first and second reference voltages may be adjustable and wherein adjusting the first and second reference voltages changes the degree of smoothing provided by the smoothing circuit when operating in the current-limiting mode.

In one or more embodiments, the power ramping circuit may further comprise a reference voltage circuit comprising a current source and a current mirror configured to provide the first and second reference voltages to the first and second CLT control terminals, respectively.

In one or more embodiments, the current mirror may be a variable current mirror and wherein a degree of current restriction, and thereby a ramping speed of the power ramping circuit, can be changed by varying the variable current mirror.

In one or more embodiments, the reference voltage circuit may further comprise: a first current mirror transistor, CMT, comprising a first CMT conduction channel and a first CMT control terminal; a second current mirror transistor, CMT, comprising a second CMT conduction channel and a second CMT control terminal; and a further transistor comprising a further transistor conduction channel and a further transistor control terminal, wherein: the first CMT control terminal is coupled to the second CMT control terminal; the current source is coupled to a first terminal of the first CMT conduction channel; the current source is further coupled to the first CMT control terminal; a second terminal of the first CMT conduction channel and a second terminal of the second CMT conduction channel are coupled to a reference node; a first terminal of the second CMT conduction channel is coupled to a second terminal of the further transistor conduction channel; a first terminal of the further transistor current channel is coupled to a second positive supply node; and the further transistor control terminal is coupled to the second terminal of the further transistor conduction channel, and wherein: the first CLT control terminal of each ramp slice circuit is coupled to the first CMT control terminal and the second CMT control terminal; and the second CLT control terminal of each ramp slice circuit is coupled to the first terminal of the second CMT conduction channel.

In one or more embodiments, in the digital power ramp mode, the sequence of in which the ramp slice circuits are activated may be based on a look-up table.

According to a second aspect of the present disclosure, there is provided a wireless transmitter device comprising the power ramping circuit of any of the first aspect.

According to a third aspect of the present disclosure, there is provided a key fob comprising the wireless transmitter device of the second aspect.

According to a fourth aspect of the present disclosure, there is provided a vehicle comprising the wireless transmitter device of the second aspect.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Figure 1 shows an example embodiment of a power ramping circuit of the present disclosure;
Figure 2 shows an example embodiment of a ramp slice circuit of the present disclosure;
Figure 3 shows an example reference voltage circuit of the present disclosure; and
Figure 4 shows simulations of gain applied to a signal generated using each of a current-limiting mode and a non-current-limiting mode;
Figure 5 shows simulations of the RF spectrum of two transmitted signal generated by a transmitter receiving a signal from the power ramping circuit using each of a current-limiting mode and a non-current-limiting mode;
Figure 6 shows an example wireless transmitter device of the present disclosure;
Figure 7 shows an example vehicle comprising the wireless transmitter device of the present disclosure; and
Figure 8 shows an example key-job comprising the wireless transmitter device of the present disclosure.

## Detailed Description

The present disclosure is directed towards a power ramping circuit which is configured to selectively operate in one of two modes. A first mode may be a non-current-limiting mode during which a plurality of ramp slice circuits are each able to generate a signal which, when combined, can be used by a transmitter to output a wireless signal. Of course, additional processing steps may be performed on the signal prior to transmission. The second mode may be a current-limiting mode in which current provided to amplifiers of the ramp slice circuits is restricted so as to introduce an artificial slowing of the output signal voltage ramp generated by each ramp slice circuit.

The power ramping circuit of the present disclosure provides for a hybrid ramping mechanism that allows for operation in the two desired modes, each of which may have particular advantages in different situations. In particular, it may be desirable in certain national jurisdictions to meet local regulations relating to spurious emissions in the vicinity of Industrial, Scientific and Medical (ISM) bands. Some jurisdictions may have more stringent requirements on such spurious emissions and so providing a single power ramping circuit which can meet any desired requirements may be particularly efficient and allow for a single device to be manufactured which can be switched to meet local requirements.

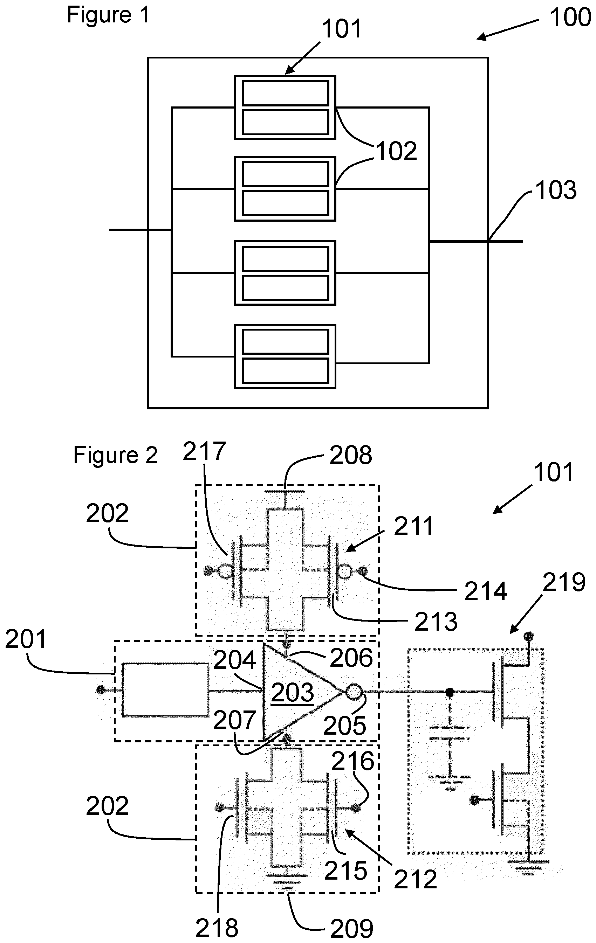

Figure 1 shows an example power ramping circuit 100 according to the present disclosure. The power ramping circuit 100 is configured for coupling to a transmitter and the output signal of the power ramping circuit 100 is configured to be usable by a transmitter, or a signal directly derived from the power ramping circuit 100 may be configured to be usable by a transmitter, to generate a wireless signal.

The power ramping circuit 100 comprises a plurality of ramp slice circuits 101 wherein each ramp slice circuit 101 is configured to, upon activation, provide a signal output voltage at its output terminal 102. The power ramping circuit 100 is further configured to combine the signal output voltages of the plurality of ramp slice circuits 101 in order to provide a combined output signal as the output of the power ramping circuit 100 at an output terminal 103 of the power ramping circuit 100. For example, the ramp slice circuits 101 may be arranged in parallel such that their outputs are combined prior to being provided at the output terminal 103 of the power ramping circuit 100. It will be appreciated that alternative arrangements of the ramp slice circuits 101 may also be used in order to separately generate the desired output signals and combine those signals into a combined output signal.

Activation of one or more or each of the ramp slice circuits 101 may be controlled by a component of the power ramping circuit 100 or the power ramping circuit 100 may be configured to receive a control input signal from a controller external to the power ramping circuit 100 wherein the controller is configured to control the activation of the ramp splice circuits 101. In one or more examples, the activation of the ramp slice circuits 101 may be controlled by a controller comprising a look-up table. The look-up table may be configured to determine the sequence in which each ramp slice circuit 101 is activated. The look-up table may be configured to define the sequence in which to activate each ramp slice circuit 101 when a smoothing circuit (described below) is operating in a non-current-limiting mode. The ramp slice circuit 101 may be configured to operate in the non-current limiting mode when operating in a digital power ramp mode (described below).

Figure 2 shows an example embodiment of a ramp slice circuit 101 which comprises a buffer amplifier 201 circuit, a smoothing circuit 202, and a power amplifier circuit 219.

The buffer amplifier circuit 201 is configured to receive an input control signal and provide the driving voltage necessary (the control output signal) for the control of the power amplifier 219 of the slice. The amplification/buffering of the input control signal is provided by at least a buffer amplifier 203 comprising an input terminal 204 for receiving the input control signal and an output terminal 205 configured to provide the output control voltage of the ramp slice circuit 101 to the power amplifier 219 of the slice. The buffer amplifier 203 further comprises a positive supply terminal 206 and a negative supply terminal 207. The positive supply terminal 206 is couplable to a positive supply node 208 and the negative supply terminal 207 is couplable to a reference node 209. Any suitable amplifier or buffer may be used.

The positive supply node 208 may be a node which is set to a relative voltage that is greater than the reference node 209. For example, the reference node 209 may be set to a relative 0 V and, as such, the positive supply node 208 may be set to any positive voltage value. It will be appreciated, however, that the reference node 209 may be set to any suitable reference voltage and this may not be zero volts. Similarly, the positive supply node 207 may be set to any suitable value. It will further be appreciated that the terms positive and negative are used herein as useful nomenclature for differentiating the features of the circuits disclosed herein, however, any circuit may be equivalently redesigned such that the polarity of the circuit is reversed and, in doing so, the polarity of the components are reversed. For example, an NPN MOSFET may be replaced with a PNP MOSFET if appropriate other changes are made to the polarity of the circuit and its components.

Further, any reference node referred to herein may comprise a ground node set to a relative 0 volts or any reference node may be set to a same relative voltage of one or more of the other reference nodes, or one or more reference nodes may be set to different reference voltages, as is appropriate to enable operation of the respective circuits in the described manner. It will further be appreciated that, typically, reference nodes, such as a ground node, are only considered coupled to ground when coupled to a power source. As such, references to terminals being couplable to a reference node or positive supply node are understood by the skilled person as being a clear reference that such an buffer circuit does not need to be coupled to a power source to be a circuit according to the present disclosure but is configured to be so coupled in use.

The smoothing circuit 202 is configured to selectively operate in a current limiting mode and a non-current-limiting mode. For ease of depiction, the smoothing circuit 202 is shown as being formed of two parts 202 in figure 2.

In the current-limiting mode, the smoothing circuit 202 is configured to restrict the current received by the amplifier 203 at the positive supply terminal 206 and the negative supply terminal 207. That is, the smoothing circuit 202 may comprise one or more components which can reduce the current between the positive supply node 208 and the positive supply terminal 206 and further components which can restrict the current flow between the reference node 209 and the negative supply terminal 205.

In the non-current limiting mode, the smoothing circuit 202 may be configured to not restrict the current received by the amplifier 203 at the positive supply terminal 206 and the negative supply terminal 207. That is, the components of the smoothing circuit 202 which provide for current restriction may be deactivated, disconnected or bypassed in order to provide for unrestricted flow of current from the positive supply node 208 and the reference node 209 to the positive supply terminal 206 and the negative supply terminal 207 of the amplifier 203, respectively.

The degree of current restriction may be adjustable. The restriction of the current to the amplifier 203 by the smoothing circuit 202 causes the gain applied by the amplifier 203 to be increased more steadily than if the current were unrestricted. This results in a gradual increase in gain applied by each amplifier 203 of each ramp slice circuit 101 in comparison to a discrete (or near-discrete) step in gain provide by each ramp slice circuit 101. This may take what appears to be a digital signal to a signal increase that appears to mimic a steady or smooth gain increase.

In one or more embodiments, the smoothing circuit 202 may comprise a first current limiting transistor 211, CLT, wherein the first CLT 211 comprises a first CLT conduction channel 213 and a first CLT control terminal 214. The first CLT conduction channel 213 may be arranged between the positive supply node 208 and the positive supply terminal 206 of the amplifier 203. Similarly, the smoothing circuit 202 may comprise a second current limiting transistor 212, CLT, wherein the second CLT 212 comprises a second CLT conduction channel 215 and a second CLT control terminal 216. The second CLT conduction channel 215 may be arranged between the reference node 209 and the negative supply terminal 207 of the amplifier 203. The first and second CLTs 211, 212 may be configured provide for restriction of the current to the positive and negative supply terminals 206, 207 of the amplifier 203.

In embodiments comprising first and second current limiting transistors 211, 212, control of the current restriction may be provided by way of adjusting the voltage at each respective control terminal 214, 216. For example, the first CLT control terminal 214 may be coupled to a first reference voltage and the second CLT control terminal 216 may be coupled to a second reference voltage. The first and second reference voltages may be different or they may be the same. The first and second reference voltages may be fixed voltages or they may be variable, programmable or otherwise adjustable voltages. Adjusting the first and second reference voltages may adjust a degree of smoothing applied by the smoothing circuit 202.

The power amplifier circuit is configured to receive the control output voltage at a control node thereof. The power amplifier circuit is configured to amplify a signal input voltage based on the received control output voltage received from the buffer circuit in order to provide a signal output voltage. The power amplifier circuit may be implemented in a range of different ways and the example provided in figure 2 is one such implementation. The control output voltage from the buffer circuit may enable or disable the power amplifier circuit in order to either turn on or turn off an output signal. Further, the magnitude of the control output voltage is able to vary the degree of gain applied to the signal input voltage, such that a steadily increasing control output voltage may cause the gain applied to the signal input voltage to increase.

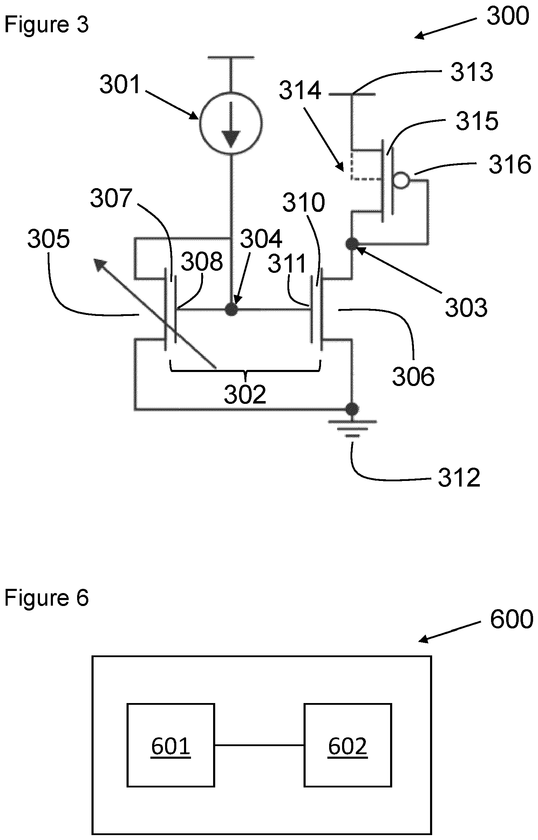

Figure 3 shows an example reference voltage circuit 300 which comprises a current source 301 and a current mirror 302 configured to provide a first reference voltage 303 and a second reference voltage 304 to the first and second CLT control terminals 214, 216, respectively. As mentioned above, the magnitude of the first and second reference voltages 303, 304 may control a degree of smoothing applied by the first and second current-limiting transistors 211, 212 of the smoothing circuit 200. It will be appreciated that the first and second reference voltages 303, 304 applied to the control terminals 214, 216 of the first and second current limiting transistors 211, 212 are different to the reference voltage provided at the reference node 209, where the reference voltage at the reference node 209 may be, for example, a ground voltage. For the avoidance of doubt, the first and second reference voltages 303, 304 may be referred to as a first CLT reference voltage 303 and a second CLT reference voltage 304, respectively. In order to provide for the control of the first and second reference voltages 303, 304, the current mirror 302 may be a variable current mirror 302 wherein a degree of current restriction, and thereby a ramping speed of the power ramping circuit 101, can be changed by varying the variable current mirror 302. Varying the variable current mirror 302 may comprise adjusting the ratio of the effective sizes of the first and second transistors 305, 306 which form the current mirror 302.

The reference voltage circuit 300 may, in particular, comprise a first current mirror transistor, CMT, 305 comprising a first CMT conduction channel 307 and a first CMT control terminal 308. It may also comprise a second current mirror transistor 306, CMT, comprising a second CMT conduction channel 310 and a second CMT control terminal 311. It may further comprise a further transistor 314 comprising a further transistor conduction channel 315 and a further transistor control terminal 316. The first CMT control terminal 308 may be coupled to the second CMT control terminal 311 such that the first and second CMTs 305, 306 are provided "back-to-back". The current source 301 may be coupled to a first terminal of the first CMT conduction channel 307 and to the first CMT control terminal 308, as may be typical in current mirror arrangements. The second terminal of the first CMT conduction channel 307 and a second terminal of the second CMT conduction channel 310 may be coupled to a reference node 312 which may be configured to receive a reference voltage such as a ground voltage in use. The first terminal of the second CMT conduction channel 310 may be coupled to a second terminal of the further transistor conduction channel 315. A first terminal of the further transistor current channel 315 may be coupled to a positive supply node 313 wherein the positive supply node 313 may be set to a same voltage level as the positive supply node 208 of the ramp slice circuit. The further transistor control terminal 316 may be coupled to the second terminal of the further transistor conduction channel 315. The first CLT control terminal 214 of each ramp slice circuit 101 may be coupled to the first CMT control terminal 308 and the second CMT control terminal 311 to provide the first reference voltage 303. The second CLT control terminal 216 of each ramp slice circuit 101 may be coupled to the first terminal of the second CMT conduction channel 310 to provide the second reference voltage 304. Thus, in this way the first and second reference currents are generated by the reference voltage circuit.

Returning to figure 3, in addition, or alternatively, the current restriction may be controlled by providing a first smoothing switch 217 coupled in parallel with the first CLT 211 and a second smoothing switch 218 coupled in parallel with the second CLT 212. Opening and closing the first and second smoothing switches 217, 218 may provide for selection of operation in the current-limiting mode or the non-current-limiting mode. For example, closing the first and second smoothing switches 217, 218 may effectively provide an alternative and unrestricted route for the current to reach the amplifier 203 which does not require going via the current limiting transistors 211, 212. This may be particularly advantageous, as it means that the voltage at the control terminals 214, 216 of the first and second CLTs 211, 212 does not need to be varied. Instead, these can be held constant, and the routing of the current can be controlled by the smoothing switches 217, 218. The smoothing switches 217, 218 may be transistors, such as MOSFET transistors or they may be other types of switches.

It will be appreciated that, while different types of transistors use different nomenclature for their various terminals, and some transistors have additional terminals, a common feature of transistors is the presence of a conduction channel which can act as a switch or variable resistor controlled by a voltage applied at a control terminal. In some examples the control terminal may comprise a base or a gate. In some examples, the terminals of the conduction channel may comprise a collector and an emitter or a source and a drain.

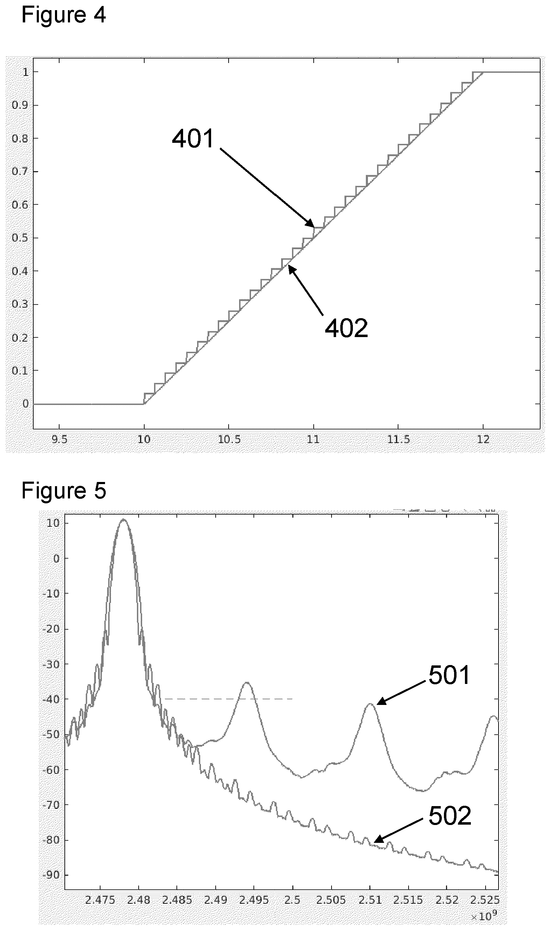

Figure 4 provides a simulation depicting how the output signal of the power ramping circuit may look when operating in a digital power ramp mode or in an analogue power ramp mode. Time is represented in microseconds along the x-axis while normalised intensity is depicted along the y-axis. It can be seen that the output signal 401 generated during operation in a non-current-limiting mode provides a stepped output voltage. In contrast, it can be seen that operating in the current-limiting mode provides a substantially continuous power ramp as an output signal 402.

Figure 5 shows the simulations of the wireless signals generated by a transmitter in response to receiving the output signal of the power ramping circuit using a digital power ramp mode and an analogue power ramp mode. Frequency in GHz is provided along the x-axis (thereby depicting the signals in Fourier space) while amplitude is provided along the y-axis. It can be seen that the signal 501 generated using the output of the power ramping circuit when operating in the non-current-limiting mode results in large spurious peaks. In contrast, it can be seen that the signal 502 generated using the output of the power ramping circuit when operating in the current-limiting mode results in significantly smaller or no spurious peaks. The small peaks in the simulation may result from the inherently digital nature of the simulation and may be expected to disappear in non-simulated results.

In the digital power ramp mode, the power ramping circuit 100 may be configured to activate each ramp slice circuit 101 sequentially in the non-current-limiting mode. By operating in such a mode, the gain applied by the power ramping circuit 100 will be provided in what may appear to be substantially discrete steps, resulting in a stepped ramp in power, as shown in figure 5. As shown in figure 6, the output signal generated while operating in the digital power ramp mode provides for significant spurious signals. The signal generated by the output signal may be defined as follows:

$$X(j\omega) = 2a_{main} \frac{\sin\left(\frac{\omega \Delta t_{main}}{2}\right)}{\omega} \left(e^{-j\omega t_{main}}\right) + 2\sum_{i=1}^{n} a_i \frac{\sin\left(\frac{\omega \Delta t_s}{2}\right)}{\omega} \left(e^{-j\omega t_{ui}} + e^{-j\omega t_{di}}\right)$$

Wherein: $a_{main}$ and $a_i$ represent amplitude factors of the main and spurious signals, respectively; $\omega$ represents the angular frequency of the signals; and $\Delta t_{main}$ and $\Delta t_s$ represent the duration at which the signal is maintained for output of the desired wireless signal and the duration of each step of the ramp, respectively. The summed term of the equation represents the spurious emission signals which manifest at frequency intervals of $1/\Delta t_s$. While the amplitude of the spurious emissions relative to the main emission can be decreased to some extent by increasing the number of ramp slice circuits, this does not eliminate the spurious emissions entirely and also increases overall circuit size.

In the analogue power ramp mode, the power ramping circuit 100 may be configured to activate each of the ramp slice circuits 101 simultaneously and operate in the current-limiting mode. By operating in the current-limiting mode, the gain applied by the power ramping circuit 100 will be provided in what may appear to be a substantially gradual and linear increase in contrast to a setoff substantially discrete steps. Depending on the amount of smoothing applied by the smoothing circuit 202, the gain applied by the power ramping circuit 100 may instead appear to provide an output signal as a set of smoothed steps, however, this may not be desirable. In the case where the output signal is provided as a substantially continuously increasing linear function, the $\Delta t_s$ of the above equation may tend to zero, thereby sending spurious emissions signals at intervals of $1/\Delta t_s$ to infinity, thereby effectively removing the spurious emissions. It may be noted that the apparently small spurious peaks that can be seen in figure 6 result from the discrete nature of the simulation, since this is not able to estiamte a truly linear function.

Figure 6 shows an example transmitter device 600 that comprises the power ramping circuit 601 of any of claims 1 - 11. The transmitter device 600 may further comprise a transmitter 602 which may be, for examples a transceiver.

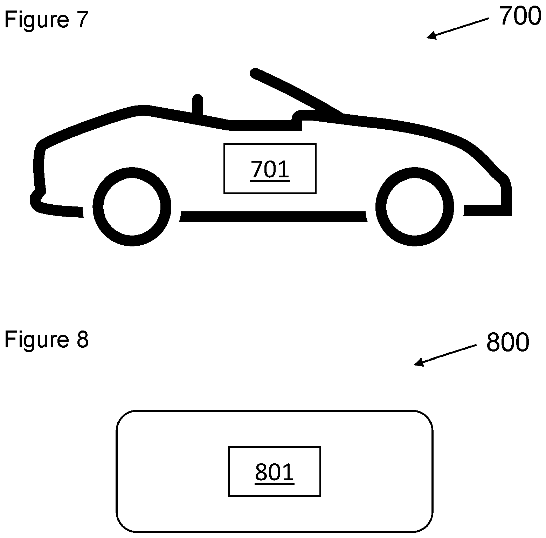

Figure 7 shows an example vehicle 700 comprising the transmitter device 701 of the present disclosure.

Figure 8 shows an example key-fob 800 comprising the transmitter device 801 of the present disclosure.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A power ramping circuit configured to generate a combined output signal for use by a wireless transmitter to generate a wireless signal, the power ramping circuit comprising:
   a plurality of ramp slice circuits wherein each ramp slice circuit is configured to, upon activation, provide an output voltage, wherein the power ramping circuit is configured to combine the output voltages of the plurality of ramp slice circuits in order to provide the combined output signal, and wherein each ramp slice circuit comprises:

   a buffer circuit comprising a buffer amplifier wherein the buffer amplifier comprises: an input terminal; an output terminal configured to provide the output control voltage of the ramp slice circuit; a positive supply terminal couplable to a positive supply node; and a negative supply terminal couplable to a reference node; and
   a smoothing circuit configured to selectively operate in a current-limiting mode and a non-current-limiting mode, an RF power amplifier which is configured to amplify an input signal and wherein the amplification applied by the RF power amplifier is controlled by the buffer circuit,

   wherein:

   in the current-limiting mode, the smoothing circuit is configured to restrict the current received by the buffer amplifier at the positive supply terminal and the negative supply terminal; and
   in the non-current limiting mode, the smoothing circuit is configured to not restrict the current received by the buffer amplifier at the positive supply terminal and the negative supply terminal.

2. The power ramping circuit of claim 1 where the power ramping circuit is configured to selectively operate in either:

   a digital power ramp mode wherein the power ramping circuit is configured to activate each ramp slice circuit sequentially and wherein the smoothing circuit of each ramp slice circuit is configured to operate in the non-current-limiting mode; or
   an analogue power ramp mode wherein the power ramping circuit is configured to activate each of the ramp slice circuits simultaneously and wherein the smoothing circuit of each ramp slice circuit is configured to operate in the current-limiting mode.

3. The power ramping circuit of any preceding claim wherein the plurality of ramp slice circuits are arranged in parallel.

4. The power ramping circuit of any preceding claim wherein the smoothing circuit comprises:

a first current limiting transistor, CLT, wherein the first CLT comprises a first CLT conduction channel and a first CLT control terminal wherein the voltage at the first CLT control terminal controls current flow through the first CLT conduction channel; and
a second current limiting transistor, CLT, wherein the second CLT comprises a second CLT conduction channel and a second CLT control terminal, wherein the voltage at the second CLT control terminal controls current flow through the second CLT conduction channel,

wherein:

the first CLT conduction channel is arranged between the positive supply node and the positive supply terminal of the amplifier; and
the second CLT conduction channel is arranged between the reference node and the negative supply terminal of the amplifier.

5. The power ramping circuit of claim 4 wherein the smoothing circuit further comprises a first smoothing switch coupled in parallel with the first CLT and a second smoothing switch coupled in parallel with the second CLT, wherein opening and closing the first and second smoothing switches provides for selection of the current-limiting mode or the non-current-limiting mode.

6. The power ramping circuit of claims 4-5 wherein the first CLT control terminal is coupled to a first reference voltage and the second CLT control terminal is coupled to a second reference voltage.

7. The power ramping circuit of claim 6 wherein the first and second reference voltages are adjustable and wherein adjusting the first and second reference voltages changes the degree of smoothing provided by the smoothing circuit when operating in the current-limiting mode.

8. The power ramping circuit of claim 7 further comprising a reference voltage circuit comprising a current source and a current mirror configured to provide the first and second reference voltages to the first and second CLT control terminals, respectively.

9. The power ramping circuit of claim 8 wherein the current mirror is a variable current mirror and wherein a degree of current restriction, and thereby a ramping speed of the power ramping circuit, can be changed by varying the variable current mirror.

10. The power ramping circuit of any of claims 8-9 wherein the reference voltage circuit further comprises:

a first current mirror transistor, CMT, comprising a first CMT conduction channel and a first CMT control terminal;
a second current mirror transistor, CMT, comprising a second CMT conduction channel and a second CMT control terminal; and
a further transistor comprising a further transistor conduction channel and a further transistor control terminal, wherein:

the first CMT control terminal is coupled to the second CMT control terminal;
the current source is coupled to a first terminal of the first CMT conduction channel;
the current source is further coupled to the first CMT control terminal;
a second terminal of the first CMT conduction channel and a second terminal of the second CMT conduction channel are coupled to a reference node;
a first terminal of the second CMT conduction channel is coupled to a second terminal of the further transistor conduction channel;
a first terminal of the further transistor current channel is coupled to a second positive supply node; and
the further transistor control terminal is coupled to the second terminal of the further transistor conduction channel,

and wherein:

the first CLT control terminal of each ramp slice circuit is coupled to the first CMT control terminal and the second CMT control terminal; and
the second CLT control terminal of each ramp slice circuit is coupled to the first terminal of the second CMT conduction channel.

11. The power ramping circuit of any of claims 2-10 wherein, in the digital power ramp mode, the sequence of in which the ramp slice circuits are activated is based on a look-up table.

12. A wireless transmitter device comprising the power ramping circuit of any of claims 1 - 11.

13. A key fob comprising the wireless transmitter device of claim 12.

14. A vehicle comprising the wireless transmitter device of claim 12.

## Figure 1

100

101

102

103

## Figure 2

217
208
101
202
211
214
213
201
204
206
203
219
207
205
216
202
215
212
218
209

Figure 3

Figure 6

## Figure 4

## Figure 5

Figure 7

700

701

Figure 8

800

801

Europäisches
Patentamt

European
Patent Office

Office européen
des brevets

# EUROPEAN SEARCH REPORT

**Application Number**

**EP 24 30 5803**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2006/006934 A1 (BURNS LAWRENCE [US] ET AL) 12 January 2006 (2006-01-12) * paragraph [0155] - paragraph [0160]; figures 30(b)-33 * | 1-14 | INV. H03F1/22 H03F3/193 H03F3/21 H03F3/24 H03F3/72 |
| A | US 2008/024225 A1 (TSUTSUI TAKAYUKI [JP] ET AL) 31 January 2008 (2008-01-31) * paragraph [0077] - paragraph [0095]; figures 2,3 * * paragraph [0119] - paragraph [0128]; figure 11 * | 1-14 | |
| A | CN 106 992 757 A (APPROPRIATE SEMICONDUCTOR CO LTD) 28 July 2017 (2017-07-28) * passages of the automated translation of the description corresponding to Figs. 3, 10 and 11; figures 3, 10, 11 * | 1-14 | |

TECHNICAL FIELDS
SEARCHED (IPC)

H03F

The present search report has been drawn up for all claims

| Place of search | Date of completion of the search | Examiner |
|---|---|---|
| The Hague | 8 November 2024 | Wienema, David |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 654 471 A1**

## ANNEX TO THE EUROPEAN SEARCH REPORT
## ON EUROPEAN PATENT APPLICATION NO.

EP 24 30 5803

08-11-2024

| Patent document cited in search report | Publication date | Patent family member(s) | Publication date |
|---|---|---|---|
| US 2006006934 A1 | 12-01-2006 | NONE | |
| US 2008024225 A1 | 31-01-2008 | JP 4614238 B2 | 19-01-2011 |
| | | JP 2008022419 A | 31-01-2008 |
| | | US 2008024225 A1 | 31-01-2008 |
| CN 106992757 A | 28-07-2017 | NONE | |

EPO FORM P0459

For more details about this annex : see Official Journal of the European Patent Office, No. 12/82